# EUROPEAN PATENT SPECIFICATION

(11) **EP 0 441 649 B1**
(45) Date of publication and mention of the grant of the patent: **16.08.1995**
(21) Application number: 91301043.5
(22) Date of filing: 08.02.1991
(51) Int. Cl.: G01R 27/26

(54) **Inductance and resistance measuring circuit**
Induktivitäts- und Widerstandsmessschaltung
Circuit de mesure d'inductance et de résistance

(30) Priority: 08.02.1990 GB 9002811
(43) Date of publication of application: 14.08.1991
(73) Proprietor: UPONOR BV, 5340 AT Oss (NL)
(72) Inventor: Williams, Peter Matthew, Nr. Stockport, Cheshire, SK6 5PG (GB); Page, Ralph, Ashton-on-Mersey, Sale, Cheshire (GB); Reeves, Anthony Vincent, Selston, Notts NE16 6FN (GB)
(74) Representative: Hall, Robert Leonard

(56) References cited:
- DE-A- 3 636 837
- GB-A- 2 135 066
- ELEKTOR ELECTRONICS. vol. 14, no. 159, September1988, CANTERBURY GB pages 24 - 28; 'SELF-INDUCTANCE METER'
- PATENT ABSTRACTS OF JAPAN vol. 5, no. 191 (P-92)(863) 5December 1981 & JP-
- A-56 115 960 ( SHINKUU RIKOU ) 11 September 1981

## Description

This invention relates to a circuit for measuring inductance and resistance of a load which may be, for example, a heater wire.

Elektor Electronics, vol 14, no 159, September 1988 describes at pages 24 to 28 thereof a self-inductance meter in which a current having a regular triangular waveform is passed through a test inductor and the induced e m f is rectified. The average value of the rectified voltage gives an indication of the inductance of the test inductor.

GB-A-2135066 describes the determination of the resistance of a load by sequentially applying a fixed d c voltage and a square wave signal to a voltage divider including a known impedance and the test resistance and applying the voltage across the device under test to a low pass filter and a voltage detector.

DE-A-3636837 from which the preamble of Claim 1 has been derived describes the determination of the inductance and resistance of a load wherein a summer/integrator is charged by a reference voltage source through the load and the stationary output of the summer/integrator is stored, and then the summer/integrator is subsequently discharged through the load and the stationary output of the summer/integrator is stored, enabling the inductance and resistance of the load to be calculated.

An object of the invention as defined in Claim 1 is to provide a circuit capable of measuring inductance and resistance simultaneously, thus saving time in taking measurements and not requiring sequence generators to present the measurements to other systems.

Circuits embodying the present invention may be employed, for example, in Fusion Control Units particularly for use in the control of the fusion or welding current applied to heater wires contained in plastic fittings such as pipe fittings.

It is common to join lengths of pipe together by means of tubular fittings, the fittings containing an electrical heater wire wound internally in the tubular fitting and adapted, when heated, to cause the adjacent plastic material to melt and to fuse with the material of the pipes to be joined.

The application of this principle is also used on saddles which are joined to pipes in order to provide an entry into a pipe at an angle, usually a right-angle, and in this case the heater wire is often incorporated in a disc of annular form which is curved to accommodate the curve of the saddle.

Different kinds of heater wire are used in different fittings. In general low resistance wires made of copper and copper alloys are used and high resistance wires made of aluminium and aluminium alloys are used in other applications. It is important to be able to distinguish between these different types of windings and in order to do so not only the ohmic resistance but also the inductance has to be measured.

According to the present invention, there is provided an electronic circuit according to claim 1.

Preferred features of the electronic circuit are indicated in dependent claims 2 to 4.

A preferred embodiment of the invention is described in the accompanying drawings, in which:-
Figure 1 is a circuit diagram, in block form, of a simultaneous inductance and resistance measuring circuit embodying the invention;
Figure 2 shows waveforms of current and voltage developed at different points in the circuit of Figure 1; and
Figure 3 is a perspective view of an electro-fusion control unit embodying the present invention.

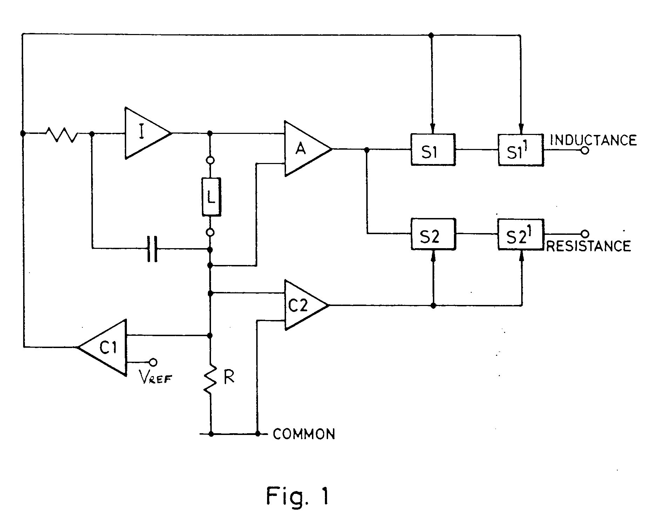

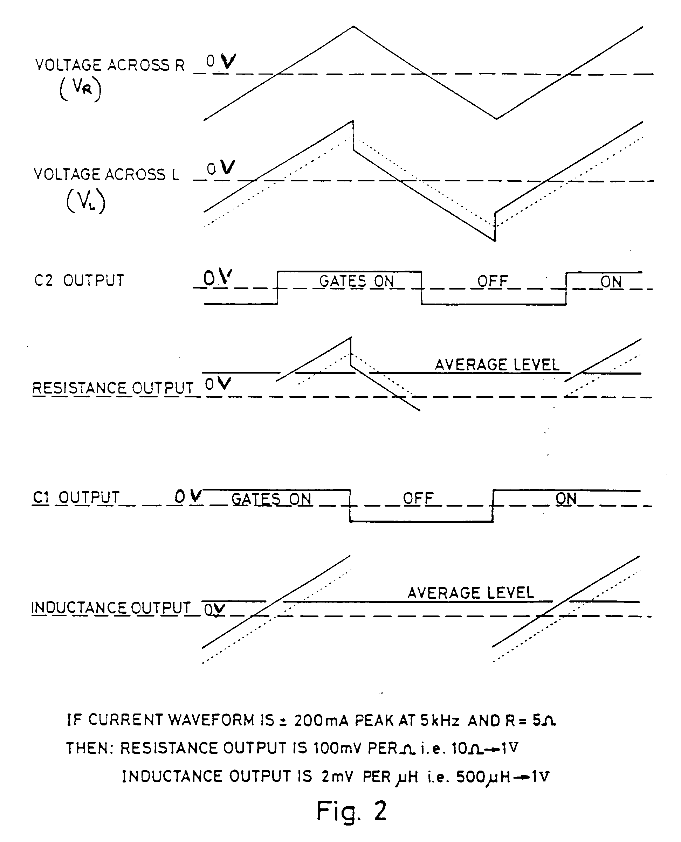

With reference to Figures 1 and 2, amplifier I forms an integrator network capable of driving a current ramp into load L under test. The current through the load creates a voltage V_{R} across a reference resistance R. The voltage V_{R} is compared with a reference voltage V_{REF} by a comparator circuit C1 which in turn presents a voltage to the input of the integrator network.

Voltage V_{REF} can be switched between two reference voltages so as to make the current through load L swing between any two desired levels. The output of comparator circuit C1 can be used to provide the two reference voltages, since it will swing between positive and negative saturation. The output of C1 can then be limited by clamping, for example, to two different levels.

The current waveform in the load L can, therefore, be in the form of a triangle, of known rate of change of current with time, and may have a d c offset of known level.

Voltage V_{L} across load L will have a resistive component and an inductive component. The resistive component is indicated in Figure 2 by the dotted line and is a triangular waveform. The rate of change of current with respect to time is constant for the ramp so that the inductive component will cause a positive d c offset on the positive ramp and a negative d c offset for the negative ramp of the triangular waveform. This results in the voltage V_{L} across load L having steps at the peaks of the waveform, as shown in Figure 2.

The resistance and inductance outputs which would arise from a purely resistive load are also represented in Figure 2 by dotted lines.

A differential amplifier A converts the voltage V_{L} across the load L to one that is referenced to common such that it will have a magnitude dependent on the impedance of the load L, i.e. both inductive and resistive components.

The output of amplifier A is averaged over the time that the rate of change of current with respect to time is constant to provide a level representative of the inductance of load L. For a current with no d c offset this averaged voltage is unaffected by the resistance of load L (so long as the integrator network I is not saturated by too high a load impedance).

To achieve this averaging the output of amplifier A is gated by S1 using the output of comparator circuit C1 as the control. Associated with Gate S1 is a low pass filter network (not shown) which also holds the average value while the gate S1 is turned off. To reduce voltage ripple on the filtered signal (which is a source of error), without greatly sacrificing speed of response, further gate circuits such as S1¹ may be added.

In a similar manner to the inductance circuit the output of amplifier A is gated by S2 and S2¹ etc, if required, and averaged. In this case, the "zero crossing points" of the current waveform are used for the control signal. The "zero crossing points" can be derived by comparing with common, the voltage developed across the reference resistance R, using comparator circuit C2. This averaged voltage represents resistance and, with or without d c offset to the current waveform, is unaffected by the inductance of load L (so long as the integrator network I is not saturated by too high a load impedance).

If a d c offset is added to the current waveform then C2 and S2 etc need not be used, and the output of amplifier A can be low pass filtered as required to provide the resistance signal direct. In this case the inductance output will have a component of resistance included. This can be easily subtracted out to return the true inductance.

The connections to load L can be those consistent with normal four terminal measurement techniques to eliminate the effects of connecting wires, i.e. the integrator network I supplies each side of load L along two "feed" wires and the input to amplifier A is made by two other "sense" wires. Amplifier A can be removed, the inductance filter and gating circuit connected to the "sense" wire from the "hot side" of load L and three other separate measurements made. These are "hot sense wire" (again), "cold sense wire" and voltage across reference resistance R. By simple algebraic manipulation of these four measurements a figure for resistance can be found the accuracy of which is essentially determined by that of reference resistance R.

By applying suitable logic to the outputs of comparator circuits C1 and C2 and adding further gating and filter circuitry, it is proposed that a further output representing circuit capacitance could be provided.

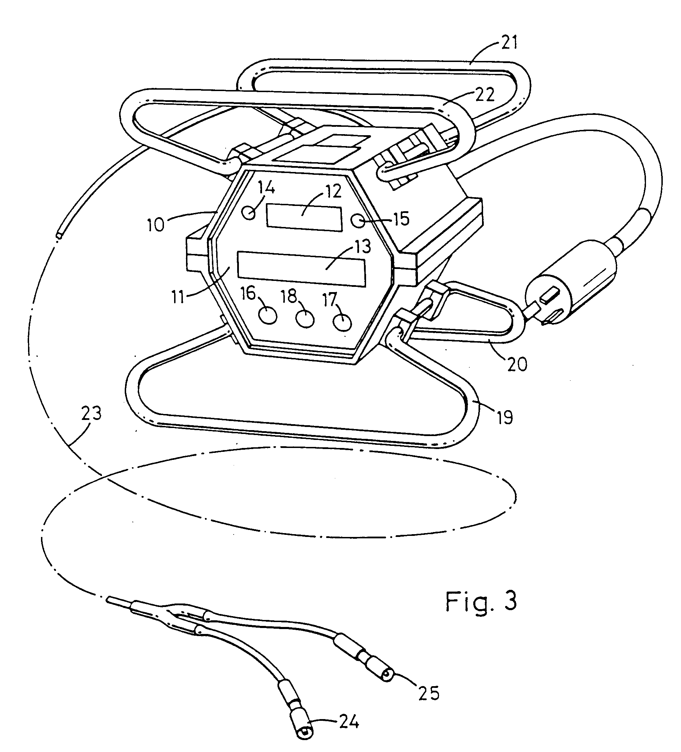

In Figure 3 a fusion control unit is shown which comprises a casing 10 which has a front panel 11 made of a plastic material which offers low impedance to transmission of infra-red signals. Within the casing is a microprocessor and the microprocessor is arranged to display fusion information in its display panel 12 and operator instructions in a display panel 13. There are high intensity LED's 14 and 15, LED 14 being red and intended to show when the heater is on and LED 15 being green and intended to show when the fusion is complete.

There is an ON button 16 and an OFF button 17 and a green light 18 which lights up to show when the fusion starts.

The casing of the unit is completely sealed against water and can stand high pressures and is made of a material highly resistant to corrosion. The casing rests on legs 19 and 20 and also has an upper pair of carrying handles 21 and 22 which may be used as legs if the unit is placed upside down.

The unit may be connected to an electro-fusion sleeve or saddle via a cable 23 which has connectors 24 and 25 to be connected to the ends of the heater wire contained in the fusion sleeve or saddle.

The resistance and inductance of the heater wire may then be measured simultaneously using the circuit shown in Figure 1 or the modification of that circuit described above. The circuits may be incorporated in the microprocessor together with the necessary instructions and logic.

## Claims

1. An electronic circuit for use in determining the inductance and resistance of a load (L), the circuit comprising an integrator network (I) characterised in that the integrator network (I) in use drives a current having a substantially regular triangular waveform through the load (L) and that the circuit comprises:
a reference resistance (R) in series with the load (L) and connected to the circuit common voltage terminal;
a first comparator circuit (C₁) whose output is connected to the input of the integrator network for comparing the voltage across the reference resistance (R) with a reference voltage;
means in the first comparator circuit (C₁) for changing the reference voltage from one value to another; and either
(i) a differential amplifier (A), for converting the voltage across the load to a voltage that is referenced to the circuit common voltage;
at least one first gate circuit (S₁, S₁') connected to the output of the differential amplifier (A) and the output of the first comparator circuit (C₁) for producing an output over a period for which the average voltage across the load (L) due to the resistance of the load (L), other than the voltage due to any DC offset current flowing in said resistance of the load (L), is zero to give a signal indicative of the inductance of the load (L);
a second comparator circuit (C₂) for indicating whether the voltage across the reference resistance (R) is positive or negative; and
at least one second gate circuit (S₂, S₂') to which the output of said second comparator circuit (C₂) is applied as a control signal and which is also connected to the output of the differential amplifier (A) for producing an output over a period for which the average voltage across the load (L) due to the inductance of the load (L) is zero, to give a signal indicative of the resistance of the load (L);
or
(ii) a differential amplifier (A) for converting the voltage across the load to a voltage that is referenced to the circuit common voltage;
at least one first gate circuit (S₁, S₁ ') connected to the output of the differential amplifier (A) and the output of the first comparator circuit (C₁) for producing an output over a period for which the average voltage across the load (L) due to the resistance of the load (L), other than the voltage due to any DC offset current flowing in said resistance of the load (L), is zero to give a signal indicative of the inductance of the load (L); and
low pass filter means for low pass filtering the output of the differential amplifier (A) to give an output over a period for which the average voltage across the load (L) due to the inductance of the load (L) is zero;
wherein a DC offset current is added to the current wave form and the output of the low pass filter means gives a signal indicative of the resistance of the load;
or
(iii) at least one first gate circuit (S₁, S₁ ') connected to the high voltage side of the load (L) and to the output of the first comparator circuit (C₁) for producing an output over a period for which the average voltage across the load (L) due to the resistance of the load (L), other than the voltage due to any DC offset current flowing in said resistance of the load (L), is zero to give a signal indicative of the inductance of the load (L); and
low pass filter means connected to the high voltage side of the load (L);
wherein said DC offset current is added to the current wave form and the output of the low pass filter means gives a signal indicative of the resistance of the load (L), and the resistance may be determined by measuring the voltage on the high voltage side of the load (L), the voltage of the low voltage side of the load (L), and the voltage across the resistance (R).

2. A circuit according to claim 1, characterised in that the circuit in use simultaneously gives the signal indicative of the inductance of the load (L) and the signal indicative of the resistance of the load (L).

3. A fusion control unit comprising a circuit according to claim 1 or 2, characterised in that the circuit is incorporated in a microprocessor contained in the unit.

4. A fusion control unit incorporating an electronic circuit according to claim 1 and simultaneously giving signals indicative of the inductance and resistance of a heater wire acting as the load (L).

## Patentansprüche

1. Elektronischer Schaltkreis zur Verwendung bei der Bestimmung des induktiven und des Ohmschen Widerstands einer Last (L), wobei der Schaltkreis ein Integrier-Netzwerk (I) aufweist, **dadurch gekennzeichnet**, daß das Integrier-Netzwerk (I) im Betrieb einen Strom mit im wesentlichen regelmäßiger, dreickiger Pulsform durch die Last (L) schickt und der Schaltkreis außerdem umfaßt:
einen in Serie mit der Last (L) geschalteten und mit dem Massespannungsanschluß des Schaltkreises verbundenen Referenzwiderstand (R),
eine erste Vergleicher-Schaltung (C₁), deren Ausgang zum Vergleich der über dem Referenzwiderstand (R) abfallenden Spannung mit einer Referenzspannung an den Eingang des Integrier-Netzwerkes angeschlossen ist,
Mittel in der ersten Vergleicher-Schaltung (C₁) zur Änderung der Referenzspannung von einem Wert zu einem anderen,
und ferner
entweder
(i) einen Differenzverstärker (A) zur Umwandlung der über der Last abfallenden Spannung in eine Spannung, die zur Massespannung des Schaltkreises in Bezug gesetzt wird,
mindestens eine erste Gate-Schaltung (S₁, S₁'), die mit dem Ausgang des Differenzverstärkers (A) und dem Ausgang der ersten Vergleicher-Schaltung (C₁) verbunden ist zur Erzeugung eines Ausgangssignales über eine Zeitdauer hinweg, bei der die mittlere, über der Last (L) abfallende und vom Ohmschen Widerstand der Last (L) herrührende Spannung, nicht aber die von irgendeinem im Widerstand der Last (L) fließenden Offset-Gleichstrom stammende Spannung, gleich Null ist, um ein Signal zu liefern, das den induktiven Widerstand der Last (L) anzeigt;
eine zweite Vergleicher-Schaltung (S₂, S₂') zur Anzeige, ob die über dem Referenzwiderstand (R) abfallende Spannung positiv oder negativ ist, und
mindestens eine zweite Gate-Schaltung (S₂, S₂'), der das Ausgangssignal der zweiten Vergleicher-Schaltung (C₂) als Steuersignal zugeführt wird und die ebenfalls mit dem Ausgang des Differenzverstärkers (A) verbunden ist zur Erzeugung eines Ausgangssignales über eine Zeitdauer hinweg, bei der die mittlere, über die Last (L) abfallende und vom induktiven Widerstand der Last herrührende Spannung gleich Null ist, um ein Signal zu liefern, das den Ohmschen Widerstand der Last (L) anzeigt,
oder
(ii) einen Differenzverstärker (A) zur Umwandlung der über der Last abfallenden Spannung in eine Spannung, die zur Massespannung des Schaltkreises in Bezug gesetzt wird,
mindestens eine erste Gate-Schaltung (S₁, S₁'), die mit dem Ausgang des Differenzverstärkers (A) und dem Ausgang der ersten Vergleicher-Schaltung (C₁) verbunden ist zur Erzeugung eines Ausgangssignales über eine Zeitdauer hinweg, bei der die mittlere, über der Last (L) abfallende und vom Ohmschen Widerstand der Last (L) herrührende Spannung, nicht aber die von irgendeinem im Widerstand der Last (L) fließenden Offset-Gleichstrom stammende Spannung, gleich Null ist, um ein Signal zu liefern, das den induktiven Widerstand der Last (L) anzeigt, und
Tiefpaßfilter-Einrichtungen zur Tiefpaßfilterung des Ausgangssignals des Differenzverstärkers (A) zur Lieferung eines Ausgangssignales über eine Zeitdauer hinweg, bei der die mittlere, über der Last (L) abfallende und vom induktiven Widerstand der Last (L) herrührende Spannung gleich Null ist,
wobei ein Offset-Gleichstrom der Strompulsform überlagert wird und der Ausgang der Tiefpaßfilter-Einrichtungen ein Signal liefert, das den Ohmschen Widerstand der Last anzeigt,
oder
(iii) mindestens eine erste Gate-Schaltung (S₁, S₁'), die mit der Seite hoher Spannung der Last (L) und dem Ausgang der ersten Vergleicher-Schaltung (C₁) verbunden ist zur Erzeugung eines Ausgangssignales über eine Zeitdauer hinweg, bei der die mittlere, über der Last (L) abfallende und vom Ohmschen Widerstand der Last (L) herrührende Spannung, nicht aber die von irgendeinem im Widerstand der Last (L) fließenden Offset-Gleichstrom stammende Spannung, gleich Null ist, um ein Signal zu liefern, das den induktiven Widerstand der Last (L) anzeigt, und
Tiefpaßfilter-Einrichtungen, die mit der Seite hoher Spannung der Last (L) verbunden sind,
wobei der Offset-Gleichstrom der Strompulsform überlagert ist und der Ausgang der Tiefpaßfilter-Einrichtungen ein Signal liefert, das den Ohmschen Widerstand der Last (L) anzeigt, wobei dieser Widerstand durch Messung der Spannung auf der Seite hoher Spannung der Last (L), der Spannung auf der Seite niedriger Spannung der Last (L) und der über den Widerstand (R) abfallenden Spannung bestimmt werden kann.

2. Schaltkreis nach Anspruch 1, dadurch gekennzeichnet, daß er im Betrieb das den induktiven Widerstand der Last (L) anzeigende Signal und das den Ohmschen Widerstand der Last (L) anzeigende Signal gleichzeitig liefert.

3. Schmelzsteuereinheit mit einem Schaltkreis nach Anspruch 1 oder 2, dadurch gekennzeichnet, daß der Schaltkreis in einem in der Einheit enthalten Mikroprozessor eingebaut ist.

4. Schmelzsteuereinheit mit einem darin eingebauten Schaltkreis nach Anspruch 1, der gleichzeitig Signale liefert, welche den induktiven und den Ohmschen Widerstand eines als Last (L) wirkenden Heizdrahtes anzeigen.

## Revendications

1. Circuit électronique destiné à être utilisé pour la détermination de l'inductance et de la résistance d'une charge (L), le circuit comprenant un réseau intégrateur (I), caractérisé en ce qu'en fonctionnement le réseau intégrateur (I) fait passer un courant possédant une forme d'onde triangulaire essentiellement régulière à travers la charge (L) et que le circuit comprend :
une résistance de référence (R) branchée en série avec la charge (L) et connectée à la borne de tension commune du circuit;
un premier circuit comparateur (C₁), dont la sortie est raccordée à l'entrée du réseau intégrateur pour comparer la tension aux bornes de la résistance de référence (R) et une tension de référence;
des moyens situés dans le premier circuit comparateur (C₁) pour modifier la tension de référence d'une valeur à une autre; et soit
i) un amplificateur différentiel (A) pour convertir la tension aux bornes de la charge en une tension qui est rapportée à la tension commune du circuit;
au moins un premier circuit de porte (S₁, S₁') connecté à la sortie de l'amplificateur différentiel (A) et à la sortie du premier circuit comparateur (C₁) pour produire un signal de sortie pendant une période pendant laquelle la tension moyenne aux bornes de la charge (L) due à la résistance de la charge (L), autre que la tension due à un quelconque courant continu d'offset traversant ladite résistance de la charge (L), est nulle de manière à produire un signal indicatif de l'inductance de la charge (L);
un second circuit comparateur (C₂) pour indiquer si la tension aux bornes de la résistance de référence (R) est positive ou négative; et
au moins un second circuit de porte (S₂, S₂'), auquel le signal de sortie dudit circuit comparateur (C₂) est appliqué en tant que signal de commande et qui est également raccordé à la sortie de l'amplificateur différentiel (A) pour produire un signal de sortie pendant une période, pendant laquelle la tension moyenne aux bornes de la charge (L) sous l'effet de l'inductance de cette charge (L) est nulle, de manière à produire un signal indicatif de la résistance de la charge (L);
soit
(ii) un amplificateur différentiel (A) pour convertir la tension aux bornes de la charge en une tension qui est rapportée à la tension commune du circuit;
au moins un premier circuit de porte (S₁, S₁') connecté à la sortie de l'amplificateur différentiel (A) et à la sortie du premier circuit comparateur (C₁) pour produire un signal de sortie pendant une période pendant laquelle la tension moyenne aux bornes de la charge (L) due à la résistance de la charge (L), autre que la tension due à un quelconque courant continu d'offset traversant ladite résistance de la charge (L), est nulle de manière à produire un signal indicatif de l'inductance de la charge (L); et des moyens formant filtre passe-bas pour appliquer un filtrage passe-bas au signal de sortie de l'amplificateur différentiel (A) pour délivrer un signal de sortie pendant une période, pendant laquelle la tension moyenne aux bornes de la charge (L) sous l'effet de l'inductance de cette charge (L) est nulle;
un courant continu d'offset étant ajouté à la forme d'onde de courant, et le signal de sortie des moyens formant filtre passe-bas délivrant un signal indicatif de la résistance de la charge;
soit
(iii) au moins un premier circuit de porte raccordé au côté haute tension de la charge (L) et à la sortie du premier circuit comparateur (C₁) pour produire un signal de sortie pendant une période, pendant laquelle la tension moyenne aux bornes de la charge (L) sous l'effet de la résistance de la charge (L), autre que la tension due à un quelconque courant continu d'offset circulant dans ladite résistance de la charge (L), est nulle pour la délivrance d'un signal indicatif de l'inductance de la charge (L); et des moyens formant filtre passe-bas connectés au côté haute tension de la charge (L);
ledit courant continu d'offset étant ajouté à la forme d'onde de courant, et le signal de sortie des moyens formant filtre passe-bas délivrant un signal indicatif de la résistance de la charge (L), et la résistance pouvant être déterminée par mesure de la tension sur le côté haute tension de la charge (L), la tension sur le côté basse tension de la charge (L) et la tension aux bornes de la résistance (R).

2. Circuit selon la revendication 1, caractérisé en ce qu'en fonctionnement le circuit délivre simultanément le signal indicatif de l'inductance de la charge (L) et le signal indicatif de la résistance de la charge (L).

3. Unité de commande de fusion comprenant un circuit selon la revendication 1 ou 2, caractérisée en ce que le circuit est incorporé dans un microprocesseur contenu dans l'unité.

4. Unité de commande de fusion comportant un circuit électronique selon la revendication 1 et délivrant simultanément des signaux indicatifs de l'inductance et de la résistance d'un fil chauffant agissant en tant que charge (L).
